# EUROPEAN PATENT APPLICATION

(11) **EP 4 664 119 A1**
(43) Date of publication of application: **17.12.2025**
(21) Application number: 23921132.9
(22) Date of filing: 09.02.2023
(51) Int. Cl.: G01R 27/02, G01R 31/389

(54) **MEASUREMENT DEVICE, POWER STORAGE SYSTEM AND MEASUREMENT METHOD**

(71) Applicant: Kabushiki Kaisha Toshiba, Tokyo 105-0023 (JP)
(72) Inventor: UEMURA, Yohei, Tokyo 105-0023 (JP); UENO, Masashi, Tokyo 105-0023 (JP); KURODA, Kazuto, Tokyo 105-0023 (JP)
(74) Representative: Hoffmann Eitle
(86) International application number: PCT/JP2023/004389
(87) International publication number: WO 2024/166301

(57) **Abstract**

In an embodiment, a measurement apparatus includes a processing circuit, the processing circuit inputs a pseudo random pulse signal of a current varying between a first current value greater than zero and a second current value greater than the first current value to a storage battery. The processing circuit measures an impedance of the storage battery based on the pseudo random pulse signal of the current input to the storage battery and a temporal change of a voltage of the storage battery in a state where the pseudo random pulse signal of the current is input to the storage battery.

## Description

### FIELD

Embodiments of the present invention relate generally to a measurement apparatus, an electricity storage system, and a measurement method.

### BACKGROUND

In diagnosis of a deterioration state of a storage battery or the like, a frequency characteristic of impedance of the storage battery is measured. In the measurement of the frequency characteristic of the impedance of the storage battery, for example, a current waveform in which a current value periodically changes is input to the storage battery at each of a plurality of frequencies, and a temporal change in the voltage of the storage battery in a state where the current waveform is input to the storage battery is measured. Then, the impedance of the storage battery at each of the plurality of frequencies is measured by performing Fourier analysis on the current waveform input to the storage battery and the temporal change of the voltage of the storage battery, and the frequency characteristic of the impedance of the storage battery is measured.

In the measurement of the frequency characteristic of the impedance of the storage battery, it is required to enable the impedance of the storage battery to be measured with a simple configuration by enabling the current to be input to the storage battery to be generated with a simple configuration. In addition, it is required to improve convenience in charging of the storage battery and measuring the impedance by enabling the impedance of the storage battery to be measured in parallel with the charging of the storage battery.

### CITATION LIST

### PATENT LITERATURE

Patent Literature 1: Jpn. Pat. Appln. KOKAI Publication No. 2013-93120
Patent Literature 2: Jpn. Pat. Appln. KOKAI Publication No. 2011-215125
Patent Literature 3: Jpn. Pat. Appln. KOKAI Publication No. 2014-126532
Patent Literature 4: Jpn. Pat. Appln. KOKAI Publication No. 2017-106889

### SUMMARY

### TECHNICAL PROBLEM

An object of the present invention is to provide a measurement apparatus, an electricity storage system, and a measurement method that enable measurement of impedance of a storage battery with an easy configuration and improve convenience in charging of the storage battery and measurement of the impedance.

### SOLUTION TO PROBLEM

According to an embodiment, a measurement apparatus includes a processing circuit, the processing circuit inputs a pseudo random pulse signal of a current varying between a first current value greater than zero and a second current value greater than the first current value to a storage battery. The processing circuit measures an impedance of the storage battery based on the pseudo random pulse signal of the current input to the storage battery and a temporal change of a voltage of the storage battery in a state where the pseudo random pulse signal of the current is input to the storage battery.

### BRIEF DESCRIPTION OF THE DRAWINGS

FIG. 1 is a schematic diagram showing an example of an electricity storage system according to a first embodiment.
FIG. 2 is a schematic diagram illustrating an example of a temporal change of each of a charge current output from an electric power supply circuit, a pseudo random pulse signal of a current input to a storage battery, and a bypass current shunted from the charge current in the first embodiment.
FIG. 3 is a schematic diagram illustrating an example of an analog signal indicating a temporal change of a voltage (inter-terminal voltage) of the storage battery in a state where a pseudo random pulse signal of a current is input to the storage battery and an analog signal of a voltage after the analog signal indicating the temporal change of the voltage is processed by a band pass filter in the first embodiment.
FIG. 4 is a schematic diagram illustrating an example of processing of measuring a frequency characteristic of impedance of a storage battery performed by a data processing section of a processing execution section in the first embodiment.
FIG. 5 is a schematic diagram illustrating an example of impedance spectrum data for frequency characteristic of impedance of the storage battery shown by a complex impedance plot measured in the first embodiment.
FIG. 6 is a schematic diagram illustrating an example of a relationship between a frequency and an absolute value of impedance of a storage battery, indicated by impedance spectrum data for frequency characteristic of impedance of the storage battery measured in the first embodiment.
FIG. 7 is a schematic diagram illustrating an example of a relationship between a frequency and a phase of an impedance of a storage battery, indicated by impedance spectrum data for a frequency characteristic of the impedance of the storage battery measured in the first embodiment.
FIG. 8 is a schematic diagram illustrating an example of averaging processing performed on impedance spectrum data that is measurement data of a frequency characteristic of impedance of a storage battery by a data processing section in the first embodiment.
FIG. 9 is a schematic diagram illustrating another example of the processing of measuring the frequency characteristic of the impedance of the storage battery, which is performed by the data processing section of the processing execution section in the first embodiment, different from FIG. 4.
FIG. 10 is a schematic diagram illustrating an example of resampling of voltage time-series data (first voltage time-series data) performed by a data processing section in the first embodiment.
FIG. 11 is a schematic diagram illustrating an example of data selection processing performed on two pieces of data after averaging processing by a data processing section in the first embodiment.
FIG. 12 is a flowchart schematically illustrating an example of processing performed by a processing execution section in the determination in regard to a state of the storage battery in the first embodiment.
FIG. 13 is a schematic diagram showing an example of an electricity storage system according to a first modification.
FIG. 14 is a schematic diagram showing an example of an electricity storage system according to a second modification.

### DETAILED DESCRIPTION

Hereinafter, embodiments will be described with reference to the drawings.

### (First Embodiment)

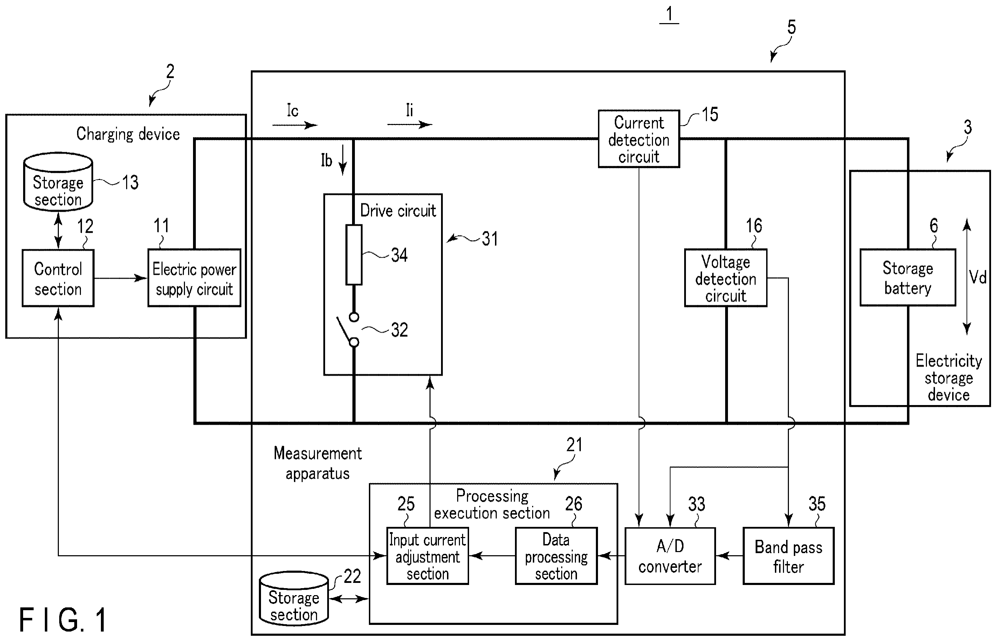

First, a first embodiment will be described as an example of the embodiment. FIG. 1 shows an example of an electricity storage system 1 according to a first embodiment. As shown in FIG. 1, an electricity storage system 1 includes a charging device 2 such as a charger, an electricity storage device 3, and a measurement apparatus 5, and the electricity storage device 3 includes a storage battery 6. In the example of FIG. 1, the charging device 2, the electricity storage device 3, and the measurement apparatus 5 are provided separately from each other. The electricity storage device 3 is mounted on, for example, a battery-mounted device (not shown). Examples of the battery-mounted device on which the electricity storage device 3 is mounted include transport vehicles for factories such as automatic guided vehicles (AGVs), stationary power supply devices, smartphones, vehicles such as electric vehicles, robots, and drones.

The storage battery 6 mounted on the electricity storage device 3 is, for example, a secondary battery such as a lithium ion secondary battery. The storage battery 6 may include a unit cell (single battery), or may be a battery module or a cell block formed by electrically connecting a plurality of unit cells. In a case where the storage battery 6 includes a plurality of unit cells, in the storage battery 6, the plurality of unit cells may be electrically connected in series, or the plurality of unit cells may be electrically connected in parallel. In the storage battery 6, both a series connection structure in which a plurality of unit cells is connected in series and a parallel connection structure in which a plurality of unit cells is connected in parallel may be formed. The storage battery 6 may be either a battery string or a battery array in which a plurality of battery modules is electrically connected.

The charging device 2 supplies electric power to the storage battery 6 for charging of the storage battery 6. The charging device 2 includes an electric power supply circuit 11, a control section 12 such as a control circuit, and a storage section 13. In the charging of the storage battery 6, a charge current Ic is output from the electric power supply circuit 11 to the storage battery 6. In the example of FIG. 1, a supply path of the charge current Ic from the electric power supply circuit 11 to the storage battery 6 is formed through the measurement apparatus 5.

The charging device 2 includes a processor, an integrated circuit, or the like, and a storage medium (non -transitory storage medium) such as a memory. In the charging device 2, the processor, the integrated circuit, or the like includes any of a central processing unit (CPU), an application specific integrated circuit (ASIC), a microcomputer, a field programmable gate array (FPGA), a digital signal processor (DSP), and the like. The charging device 2 may be provided with only one processor or a plurality of processors. In addition, only one storage medium or a plurality of storage media may be provided in the charging device 2. In the charging device 2, the processor, the integrated circuit, or the like performs processing, for example, by executing a program stored in a storage medium. Furthermore, in the charging device 2, processing of the control section 12 is performed by a processor or the like, and the storage medium functions as the storage section 13.

In the charging of the storage battery 6, the control section 12 controls the supply of electric power to the storage battery 6 by controlling the driving of the electric power supply circuit 11. The control section 12 controls driving of the electric power supply circuit 11 to adjust a charge rate or the like of charge current Ic output from the electric power supply circuit 11 to the storage battery 6.

In the example of FIG. 1, the measurement apparatus 5 includes a current detection circuit 15 and a voltage detection circuit 16. In a state of charging of the storage battery 6, the current detection circuit 15 detects an input current Ii to the storage battery 6, which is a current flowing through the storage battery 6, and the voltage detection circuit 16 detects a voltage Vd applied to the storage battery 6. The current detection circuit 15 includes, for example, a shunt resistor, and detects the current (input current Ii) of the storage battery 6 based on a voltage applied to the shunt resistor. For example, the voltage detection circuit 16 detects an inter-terminal voltage of the storage battery 6 as a voltage Vd of the storage battery 6. In one example, the current detection circuit 15 and the voltage detection circuit 16 may be provided in the electricity storage device 3.

The measurement apparatus 5 measures an impedance Z of the storage battery 6. In the example of FIG. 1, the measurement apparatus 5 measures the impedance Z of the storage battery 6 in a state where the storage battery 6 is charged by the charge current Ic output from the electric power supply circuit 11 to the storage battery 6. The measurement apparatus 5 includes a processing execution section 21 such as a processing circuit and a storage section 22, and the processing execution section 21 includes an input current adjustment section 25 and a data processing section 26. Each of the input current adjustment section 25 and the data processing section 26 executes a part of the processing performed by the processing execution section 21.

The measurement apparatus 5 includes a processor, an integrated circuit, or the like, and a storage medium (non-transitory storage medium) such as a memory. In the measurement apparatus 5, the processor, the integrated circuit, or the like includes any of a CPU, an ASIC, a microcomputer, an FPGA, a DSP, and the like. The measurement apparatus 5 may be provided with only one processor or a plurality of processors. In addition, only one storage medium or a plurality of storage media may be provided in the measurement apparatus 5. In the measurement apparatus 5, the processor, the integrated circuit, or the like performs processing by executing a program stored in a storage medium, for example. Furthermore, in the measurement apparatus 5, the processing of the processing execution section 21 is performed by a processor or the like, and the storage medium functions as the storage section 22. The processing execution section 21 including the input current adjustment section 25 and the data processing section 26 executes, for example, a measurement program stored in the storage section 22 to perform processing to be described later.

In addition, the measurement apparatus 5 includes a drive circuit 31, and in the example of FIG. 1, the drive circuit 31 includes a switch 32 and a resistor 34. The drive circuit 31 is formed in a supply path of the charge current Ic from the electric power supply circuit 11 of the charging device 2 to the storage battery 6 of the electricity storage device 3. The input current adjustment section 25 of the processing execution section 21 controls driving of the drive circuit 31 in a state where the charge current Ic is output from the electric power supply circuit 11 to the storage battery 6, and controls on/off of the switch 32, for example. As a result, the input current Ii input to the storage battery 6 is adjusted and controlled.

In the example of FIG. 1, in an off state of the switch 32 of the drive circuit 31, all of the charge current Ic output from the electric power supply circuit 11 is input to the storage battery 6. At this time, no current flows through the resistor 34 of the drive circuit 31. On the other hand, in an on state of the switch 32 of the drive circuit 31, a part of the charge current Ic output from the electric power supply circuit 11 is shunted in the drive circuit 31, and the current shunted from the charge current Ic flows through the resistor 34. The current flowing through the resistor 34 becomes a bypass current Ib that is not supplied to the storage battery 6. The remaining part of the charge current Ic that is not shunted as the bypass current Ib becomes an input current Ii input to the storage battery 6.

The input current adjustment section 25 controls switching operation of the switch 32, that is, on/off of the switch 32, thereby controlling shunting of the charge current Ic in the drive circuit 31. Then, the input current adjustment section 25 generates a pseudo random pulse signal of the current by controlling the shunting of the charge current Ic in the drive circuit 31, and inputs the generated pseudo random pulse signal of the current to the storage battery 6 as the input current Ii to the storage battery 6. Therefore, in the present embodiment, the processing execution section 21 such as a processing circuit shunts the charge current Ic output from the electric power supply circuit 11 to the storage battery 6 in the measurement of the impedance Z of the storage battery 6, thereby generating a pseudo random pulse signal of the current as the input current Ii to the storage battery 6. As the pseudo random pulse signal, for example, an M-sequence signal is used.

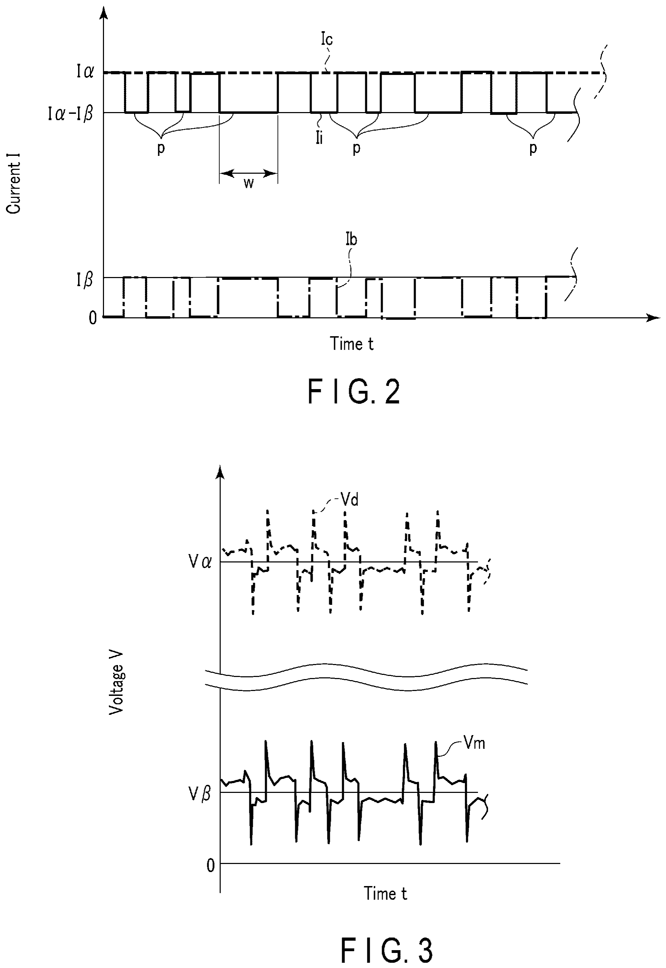

FIG. 2 illustrates an example of temporal changes of the charge current Ic output from the power supply circuit 11, a pseudo random pulse signal of a current that is the input current Ii input to the storage battery 6, and the bypass current Ib shunted from the charge current Ic. In FIG. 2, the abscissa axis represents a time t, and the ordinate axis represents a current I. In the example of FIG. 2, the charge current Ic is kept constant or substantially constant over time at a current value Iα. Then, in the off state of the switch 32 of the drive circuit 31, the charge current Ic is not divided, the pseudo random pulse signal (input current Ii) becomes a current value Iα, and the bypass current Ib becomes the current value 0. On the other hand, in the on state of the switch 32 of the drive circuit 31, a current corresponding to the current value Iβ is shunted from the charge current Ic as the bypass current Ib, and the pseudo random pulse signal (input current Ii) becomes the current value Iα-Iβ. In the example of FIG. 2, the current value Iβ is a value smaller than a half value of the current value Iα, for example, a value of about 10% of the current value Iα.

As described above, since each of the charge current Ic, the pseudo random pulse signal (input current Ii), and the bypass current Ib changes with time, in the example of FIG. 2, the bypass current Ib changes with time between zero and the current value Iβ. Then, the pseudo random pulse signal temporally changes between a current value (first current value) Iα-Iβ larger than zero and a current value (second current value) Iα larger than a current value Iα-Iβ.

In addition, the pseudo random pulse signal includes a plurality of pulses p, and in each of the plurality of pulses p, the current value of the pseudo random pulse signal is lower than the current value Iα. In the pseudo random pulse signal serving as the input current Ii to the storage battery 6, a pulse width w is defined for each of a plurality of pulses p, and at least one of the plurality of pulses p has a pulse width w different from that of the other pulses p. In addition, a pulse pmin having the smallest pulse width w among the pulses p of the pseudo random pulse signal is defined, and a pulse width wmin of the pulse pmin is defined. In the case of an M-sequence signal, in each of the plurality of pulses p, the pulse width w is an integral multiple of the pulse width wmin of the pulse pmin. In the pseudo random pulse signal, a signal length Y is defined. In one example, a signal length Y of the pseudo random pulse signal corresponds to a time from a start time point to an end time point of the switching operation of the switch 32.

In a state in which the pseudo random pulse signal of the current is input to the storage battery 6 as the input current Ii, the current detection circuit 15 detects the pseudo random pulse signal of the current, and the voltage detection circuit 16 detects the temporal change of the voltage of the storage battery 6. In addition, the measurement apparatus 5 includes an A/D converter 33 and a band pass filter (BPF) 35. An analog signal indicating a detection result in each of the current detection circuit 15 and the voltage detection circuit 16 is input to the A/D converter 33.

The A/D converter 33 converts an analog signal indicating a detection result in the current detection circuit 15, that is, an analog signal indicating a detection result of the input current Ii input to the storage battery 6, into a digital signal. In addition, the A/D converter 33 converts an analog signal indicating a detection result in the voltage detection circuit 16, that is, an analog signal indicating a temporal change of the voltage (inter-terminal voltage) Vd of the storage battery 6 into a digital signal. The A/D converter 33 performs sampling at a predetermined sampling period and converts an analog signal into a digital signal.

Furthermore, the analog signal indicating the detection result in the voltage detection circuit 16 is directly input to the A/D converter 33 as described above, and the analog signal indicating the detection result in the voltage detection circuit 16 is input to the A/D converter 33 through the band pass filter 35. The band pass filter 35 extracts only a voltage component in a specific frequency range in an analog signal indicating a temporal change of a voltage (inter-terminal voltage) Vd of the storage battery 6, and removes a voltage component outside the specific frequency range. Note that the specific frequency range does not include 0 Hz, and in one example, the specific frequency range is a frequency range of 0.1 Hz or more and 5000 Hz or less. Therefore, the voltage component of 0 Hz, that is, the voltage component caused by the direct current is removed from the analog signal indicating the detection result in the voltage detection circuit 16 by the band pass filter 35. In the analog signal indicating the temporal change of the voltage Vd, the voltage component caused by the direct current is removed, so that a voltage offset relative to 0 V decreases in the analog signal, and a center of fluctuation approaches 0 V.

FIG. 3 illustrates an example of an analog signal indicating a temporal change of the voltage (inter-terminal voltage) Vd of the storage battery 6 in a state where a pseudo random pulse signal of a current is input to the storage battery 6 as the input current Ii, and an analog signal for the voltage Vm after the analog signal indicating the temporal change of the voltage Vd is processed by the band pass filter 35. In FIG. 3, the abscissa axis represents a time t, and the ordinate axis represents a voltage V.

In the example of FIG. 3, in the analog signal indicating the temporal change of the voltage Vd, the voltage Vd fluctuates around a voltage value Vα, and has a voltage offset corresponding to the voltage value Vα relative to 0 V. On the other hand, in the analog signal indicating the temporal change of a voltage Vm, the voltage Vm fluctuates around a voltage value Vβ closer to 0 V than the voltage value Vα, and has a voltage offset corresponding to the voltage value Vβ relative to 0 V. Therefore, in the analog signal indicating the temporal change of the voltage Vm, the center of fluctuation approaches 0 V and the voltage offset relative to 0 V decreases as compared with the analog signal indicating the temporal change of the voltage Vd. In one example, in the analog signal indicating the temporal change of the voltage Vm, the voltage offset relative to 0 V decreases by a decrease amount corresponding to an open circuit voltage of the storage battery 6 as compared with the analog signal indicating the temporal change of the voltage Vd. Note that the center of fluctuation of the analog signal indicating the temporal change of the voltage Vm is 0 V or a voltage value close to 0 V. Therefore, the voltage Vm is a voltage component corresponding to a fluctuation voltage of the voltage (inter-terminal voltage) Vd of the storage battery 6.

The A/D converter 33 converts an analog signal of the voltage Vm whose voltage offset relative to 0 V has been reduced by the band pass filter 35 into a digital signal. Then, the three types of digital signals converted by the A/D converter 33 are input to the data processing section 26 of the processing execution section 21. Therefore, a digital signal for the input current Ii input to the storage battery 6, a digital signal for the voltage (inter-terminal voltage) Vd of the storage battery 6, and a digital signal for the voltage Vm obtained by reducing the voltage offset relative to 0 V are input to the processing execution section 21. In a state where a pseudo random pulse signal of a current is input to the storage battery 6, a digital signal for the pseudo random pulse signal is input to the processing execution section 21 as a digital signal for the input current Ii to the storage battery 6.

Here, in a state where the pseudo random pulse signal of the current is input to the storage battery 6 as the input current Ii, data indicated by the digital signal for the pseudo random pulse signal is set as a current time-series data (first current time-series data) Ii1(t), data indicated by the digital signal for the voltage (inter-terminal voltage) Vd of the storage battery 6 is set as inter-terminal voltage time-series data Vd(t), and data indicated by the digital signal for the voltage Vm with a reduced voltage offset relative to 0 V is set as voltage time-series data (first voltage time-series data) Vm1(t). The current time-series data Ii1(t) is data based on the pseudo random pulse signal input to the storage battery 6 as the input current Ii, and the inter-terminal voltage time-series data Vd(t) and the voltage time-series data Vm1(t) are data based on the temporal change of the voltage of the storage battery 6 in a state where the pseudo random pulse signal is input to the storage battery 6.

The data processing section 26 of the processing execution section (processing circuit) 21 measures the frequency characteristic of the impedance Z of the storage battery 6 using the current time-series data Ii1(t) and the voltage time-series data Vm1(t). Therefore, the impedance Z of the storage battery 6 and the frequency characteristic of the impedance Z of the storage battery 6 are measured based on the pseudo random pulse signal of the current input to the storage battery 6 and the temporal change in the voltage of the storage battery 6 in a state where the pseudo random pulse signal of the current is input to the storage battery 6.

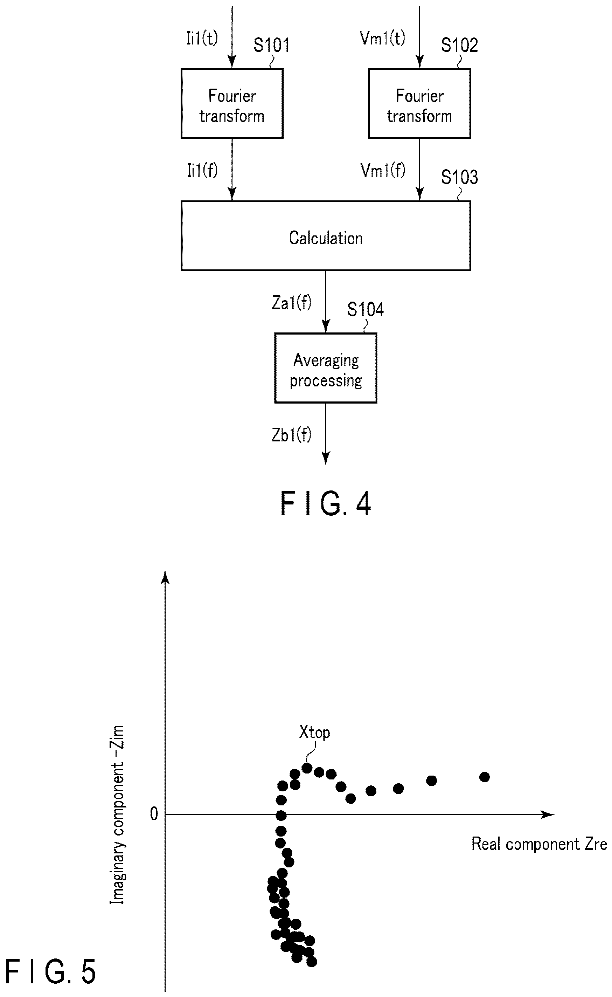

FIG. 4 illustrates an example of processing of measuring the frequency characteristic of the impedance Z of the storage battery 6 performed by the data processing section 26 of the processing execution section 21. In the example of FIG. 4, the data processing section 26 subjects the current time-series data Ii1(t) for the pseudo random pulse signal that is the input current Ii to the storage battery 6 to Fourier transform by fast Fourier transform or the like (S101). As a result, current spectrum data (first current spectrum data) Ii1(f) indicating frequency characteristic of the pseudo random pulse signal that is the input current Ii to the storage battery 6 is calculated. In addition, the data processing section 26 performs Fourier transform on the voltage time-series data Vm1(t) for the voltage Vm in a state where the pseudo random pulse signal is input to the storage battery by fast Fourier transform or the like (S102). As a result, voltage spectrum data (first voltage spectrum data) Vm1(f) indicating frequency characteristic of the voltage Vm that is a voltage component corresponding to the fluctuation voltage of the storage battery 6 is calculated.

In the current spectrum data Ii1(f), current components at each of a large number of frequencies included in the measurement frequency range to be measured are indicated for the pseudo random pulse signal that is the input current Ii. The voltage spectrum data Vm1(f) indicates voltage components of the voltage Vm at each of a large number of frequencies included in the measurement frequency range to be measured. The measurement frequency range in the current spectrum data Ii1(f) and the voltage spectrum data Vm1(f) corresponds to a measurement frequency range for measuring the impedance Z in the measurement of the frequency characteristic of the impedance Z of the storage battery 6. In addition, the measurement frequency range in the current spectrum data Iil(f) and the voltage spectrum data Vm1(f) is included within the above-described specific frequency range from which the voltage component is not removed by the band pass filter 35.

Then, the data processing section 26 performs calculation using the current spectrum data Ii1(f) and the voltage spectrum data Vm1(f) (S103), and calculates impedance spectrum data (first impedance spectrum data) Zal(f) indicating the frequency characteristic of the impedance Z of the storage battery 6. The impedance spectrum data Zal(f) is calculated, for example, by dividing the voltage spectrum data Vm1(f) by the current spectrum data Ii1(f). In the impedance spectrum data Zal(f), for the impedance Z of the storage battery 6, impedance components at each of a large number of frequencies included in the above-described measurement frequency range are shown. At a frequency at which an impedance component is indicated in the impedance spectrum data Zal(f), a current component is indicated in the current spectrum data Ii1(f) and a voltage component is indicated in the voltage spectrum data Vm1(f).

Patent Literature 3 (Jpn. Pat. Appln. KOKAI Publication No. 2014-126532) discloses a method for calculating impedance spectrum data for impedance of a storage battery using current time-series data for current of the storage battery and voltage time-series data for voltage of the storage battery. In the embodiment and the like, impedance spectrum data indicating the frequency characteristic of the impedance Z of the storage battery 6 may be calculated in the same manner as in Patent Literature 3. In this case, the data processing section 26 calculates an autocorrelation function of the current spectrum data Ii1(f) and calculates a cross-correlation function between the current spectrum data Ii1(f) and the voltage spectrum data Vm1(f). Then, the data processing section 26 calculates impedance spectrum data for the impedance Z of the storage battery 6 using the calculated autocorrelation function and cross-correlation function.

The impedance spectrum data Zal(f), which is measurement data obtained by measuring the frequency characteristic of the impedance Z of the storage battery 6 as described above, can be indicated by a complex impedance plot (Cole-Cole plot). FIG. 5 is a complex impedance plot showing an example of impedance spectrum data Zal(f) for the frequency characteristic of the impedance Z of the storage battery 6. As illustrated in FIG. 5, in the complex impedance plot, the abscissa axis represents a real component Zre of the impedance Z, and the ordinate axis represents an imaginary component -Zim of the impedance Z. In the example of FIG. 5, the real component and the imaginary component of the impedance Z of the storage battery 6 are shown for each of a large number of frequencies included in the measurement frequency range.

In the complex impedance plot, a distance from an origin is an absolute value (magnitude) |Z| of the impedance Z. In addition, in the complex impedance plot, a phase θ of the impedance Z is defined with a positive side of the real axis as 0. Therefore, in the impedance spectrum data Zal(f) that can be indicated by a complex impedance plot, a relationship between the frequency f and an absolute value |Z| of the impedance Z of the storage battery 6 is indicated, and a relationship between the frequency f and a phase θ of the impedance Z of the storage battery 6 is indicated.

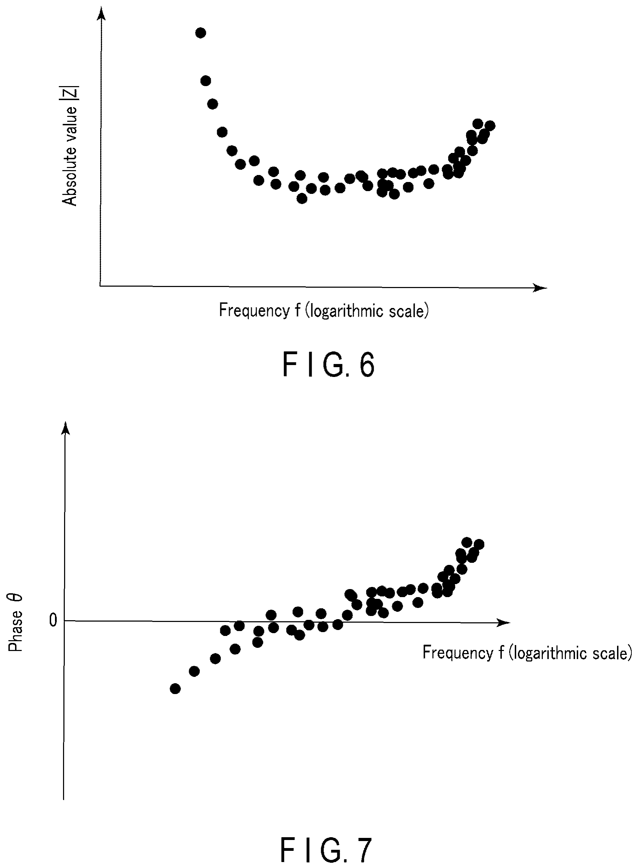

FIG. 6 shows an example of the relationship between the frequency f and the absolute value |Z| of the impedance Z of the storage battery 6, indicated by the impedance spectrum data Zal(f), for the frequency characteristic of the impedance of the storage battery 6, and FIG. 7 shows an example of the relationship between the frequency f and the phase θ of the impedance Z of the storage battery 6, indicated by the impedance spectrum data Za1(f). In FIGS. 6 and 7, the abscissa axis represents a frequency f on a logarithmic scale. The ordinate axis in FIG. 6 represents the absolute value |Z|, and the ordinate axis in FIG. 7 represents the phase θ. As illustrated in FIG. 6, the impedance spectrum data Za1(f) indicates the absolute value |Z| of the impedance Z of the storage battery 6 for each of a large number of frequencies included in the measurement frequency range. As illustrated in FIG. 7, the impedance spectrum data Zal(f) indicates the phase θ of the impedance Z of the storage battery 6 for each of a large number of frequencies included in the measurement frequency range.

In the example of FIG. 4, the data processing section 26 performs averaging processing on the impedance spectrum data Zal(f) that is the measurement data of the frequency characteristic of the impedance Z of the storage battery 6 (S104). Then, averaging-processed data (first averaging-processed data) Zb1(f), which is impedance spectrum data obtained by performing averaging processing on the impedance spectrum data Zal(f), is generated. In another example, the averaging processing of S104 may not be performed.

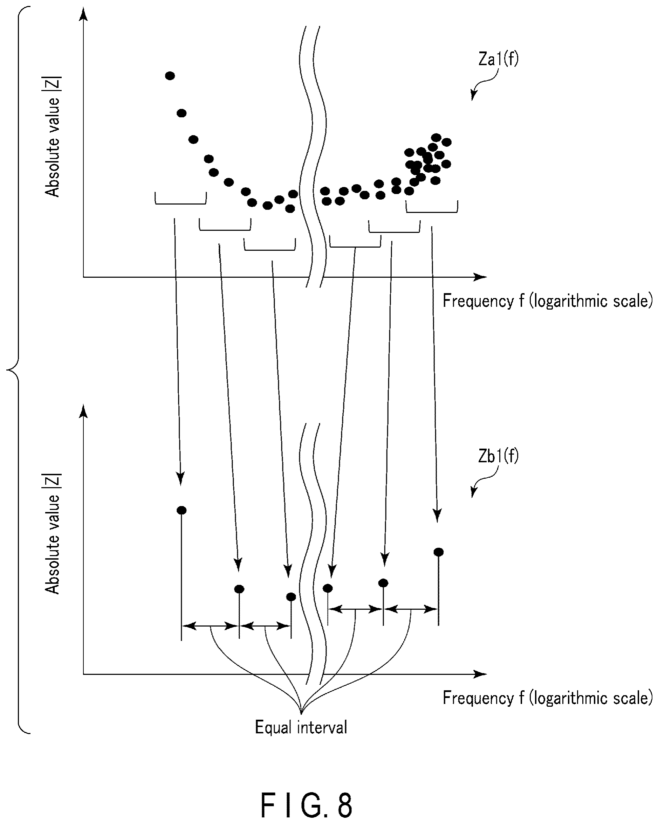

FIG. 8 illustrates an example of the averaging processing performed by the data processing section 26 on the impedance spectrum data Zal(f) that is the measurement data of the frequency characteristic of the impedance Z of the storage battery 6. In FIG. 8, the averaging processing will be described using a graph in which the abscissa axis indicates the frequency f on a logarithmic scale and the ordinate axis indicates the absolute value |Z| of the impedance Z of the storage battery 6. As illustrated in FIG. 8, one data point of the averaging-processed data Zb1(f) is calculated from a plurality of data points having frequencies f close to each other in the impedance spectrum data Zal(f) by the averaging processing by the data processing section 26.

The averaging-processed Zb1(f) generated by the averaging processing indicates the impedance Z of the storage battery 6 including the absolute value |Z| and the phase θ for each of the plurality of frequencies included in the measurement frequency range. However, the number of frequencies at which the impedance Z is indicated in the averaging-processed data Zb1(f) is smaller than the number of frequencies at which the impedance Z is indicated in the impedance spectrum data Za1(f). That is, the number of data points indicated in the averaging-processed data Zb1(f) decreases as compared with the number of data points indicated in the impedance spectrum data Za1(f).

In the averaging-processed data Zb1(f) generated by the averaging processing, the plurality of data points is at equal intervals on the logarithmic scale of the frequency f. Therefore, the data processing section 26 performs averaging processing on the impedance spectrum data Zal(f), which is the measurement data of the frequency characteristic of the impedance Z of the storage battery 6, in a state where the processed data points are at equal intervals on a logarithmic scale of the frequency f. In the averaging processing, as the frequency f increases, the number of data points of the impedance spectrum data Zal(f) used for calculating one data point of the averaging-processed data Zb1(f) increases. That is, in the data after the averaging processing, the higher the frequency f is, the more data points of the data before the averaging processing are used to calculate.

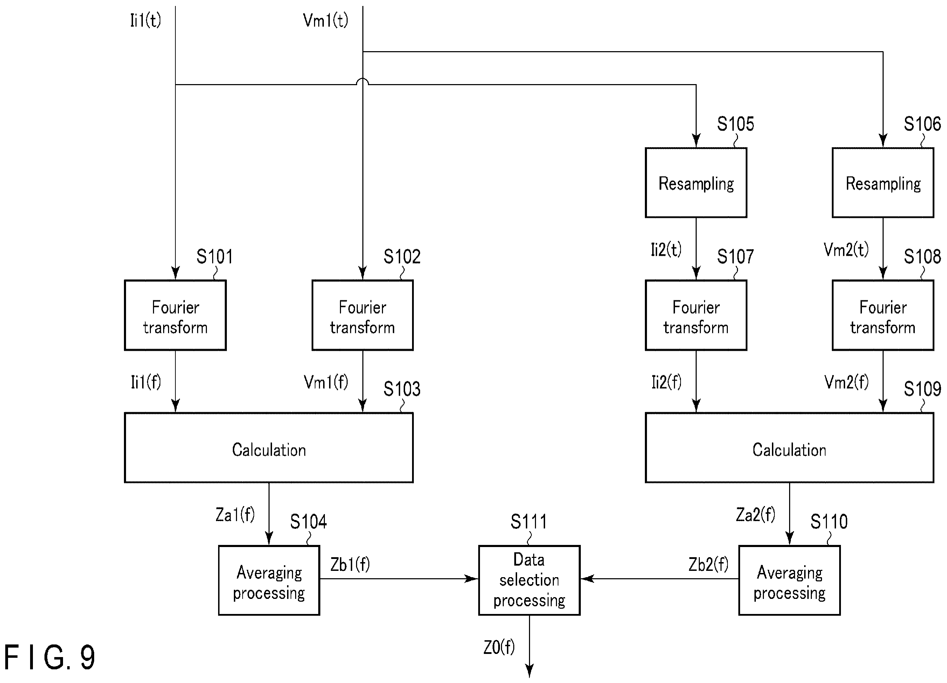

FIG. 9 illustrates another example of the processing of measuring the frequency characteristic of the impedance Z of the storage battery 6, which is performed by the data processing section 26 of the processing execution section 21, different from FIG. 4. In the example of FIG. 9, similarly to the example of FIG. 4, the processing of S101 to S104 is performed. Therefore, as described above, the impedance spectrum data (first impedance spectrum data) Zal(f) is calculated as measurement data using the current time-series data (first current time-series data) Ii1(t) and the voltage time-series data (first voltage time-series data) Vm1(t), and the averaging-processed data (first averaging-processed data) Zb1(f) is calculated by the averaging processing.

However, in the example of FIG. 9, the data processing section 26 performs resampling on the current time-series data Ii1(t) for the pseudo random pulse signal that is the input current Ii to the storage battery 6 (S105). As a result, current time-series data (second current time-series data) Ii2(t) obtained by resampling the current time-series data Ii1(t) is calculated. In addition, the data processing section 26 resamples the voltage time-series data Vm1(t) for the voltage Vm in a state where the pseudo random pulse signal is input to the storage battery (S106). As a result, voltage time-series data (second voltage time-series data) Vm2(t) obtained by resampling the voltage time-series data Vm1(t) is calculated.

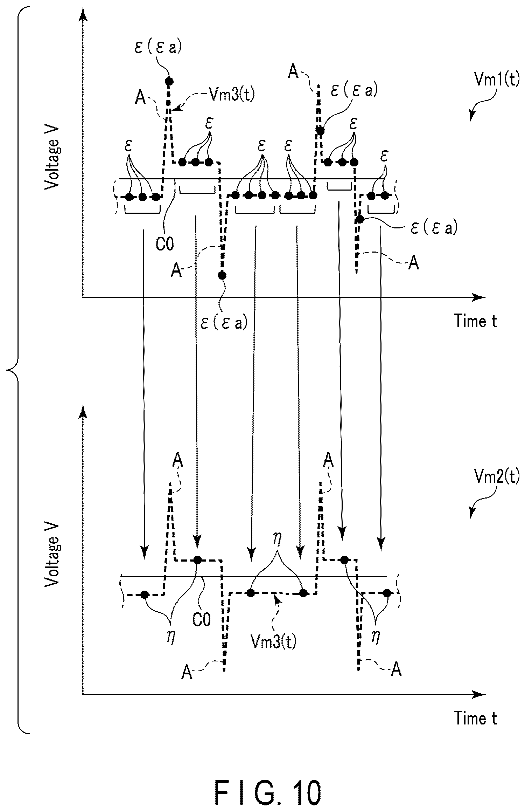

FIG. 10 illustrates an example of resampling of the voltage time-series data Vm1(t) performed by the data processing section 26. In FIG. 10, resampling will be described using a graph in which the abscissa axis indicates a time t and the ordinate axis indicates a voltage V. In FIG. 10, the analog signal Vm3(t) for the temporal change of the voltage Vm is indicated by a broken line in the graph described above. As illustrated in FIG. 10 and the like, in the analog signal Vm3(t) for the temporal change of the voltage Vm, a peak A occurs in each of a region on the high side and a region on the low side with respect to the center of fluctuation. In the region on the high side with respect to the center of fluctuation, the voltage Vm is higher in the generated peak A than in other portions, and in the region on the low side with respect to the center of fluctuation, the voltage Vm is lower in the generated peak A than in other portions. In FIG. 10, the center of fluctuation of the analog signal Vm3(t) is indicated by a center line C0.

The A/D converter 33 samples the analog signal Vm3(t) at a predetermined sampling period to generate voltage time-series data Vm1(t) as a digital signal in which a relationship of the voltage Vm with respect to the time t is indicated by data points ε. The data point ε indicated by the voltage time-series data Vm1(t) includes a data point εa existing in a time range in which the peak A occurs in the analog signal Vm3(t). In the resampling for the voltage time-series data Vm1(t), the data processing section 26 deletes the data point εa existing in the time range in which the peak A occurs from the data points ε indicated by the voltage time-series data Vm1(t). Then, the data processing section 26 performs averaging processing on the data points ε other than the deleted data point εa. That is, the data processing section 26 resamples the voltage time-series data Vm1(t) by performing averaging processing on the data points ε existing outside the time range in which the peak A occurs in the analog signal Vm3(t) .

By resampling the voltage time-series data Vm1(t) as described above, a relationship of the voltage Vm with respect to the time t is indicated by the data points η in the voltage time-series data Vm2(t) subjected to the resampling. The number of data points η in the resampled voltage time-series data Vm2(t) is smaller than the number of data points ε in the unresampled voltage time-series data Vm1(t). In addition, since the data point εa is not used in the averaging processing performed in the resampling, in the voltage time-series data Vm2(t) after the resampling, the influence of the peak A generated in the analog signal Vm3(t) in regard to the temporal change of the voltage Vm is removed.

Similarly to the analog signal Vm3(t), also in the analog signal for the pseudo random pulse signal that becomes the input current Ii to the storage battery 6, a peak occurs in each region on the high side and the region on the low side with respect to the center of fluctuation. Then, the A/D converter 33 samples the analog signal for the pseudo random pulse signal at a predetermined sampling period to generate current time-series data Ii1(t) as a digital signal in which a relationship of the input current Ii with respect to the time t is indicated by the data points. The data points indicated by the current time-series data Ii1(t) include data points existing in a time range in which a peak occurs in the analog signal for the pseudo random pulse signal.

The resampling of the current time-series data Ii1(t) is performed similarly to the resampling of the voltage time-series data Vm1(t). That is, in the resampling for the current time-series data Ii1(t), the data processing section 26 deletes the data points existing in the above-described time range in which the peak occurs from the data points indicated by the current time-series data Ii1(t). Then, the data processing section 26 performs averaging processing on data points other than the deleted data points. That is, the data processing section 26 resamples the current time-series data Ii1(t) by performing averaging processing on data points existing outside the time range in which the peak occurs in the analog signal for the pseudo random pulse signal.

By resampling the current time-series data Ii1(t) as described above, the number of data points in a current time-series data Ii2(t) after resampling is reduced as compared with the number of data points in the current time-series data Ii1(t) before resampling. In addition, in the current time-series data Ii2(t) after resampling, the influence of the peak occurring in the analog signal for the pseudo random pulse signal is removed.

As described above, in the example of FIG. 9, in the state where the pseudo random pulse signal of the current is input to the storage battery 6, the data processing section 26 resamples each of the current time-series data Ii1(t) based on the pseudo random pulse signal and the voltage time-series data Vm1(t) based on the temporal change of the voltage of the storage battery 6 to a state where the data points decrease. At this time, resampling is performed on the current time-series data Ii1(t) in a state where the influence of the peak occurring in the analog signal for the input current Ii to the storage battery 6 is removed by resampling, and resampling is performed on the voltage time-series data Vm1(t) in a state where the influence of the peak A occurring in the analog signal for the voltage Vm related to the storage battery 6 is removed by resampling.

Furthermore, in the example of FIG. 9, the data processing section 26 performs Fourier transform on the current time-series data (second current time-series data) Ii2(t) obtained by resampling the current time-series data Ii1(t) as described above by fast Fourier transform or the like (S107). At this time, the current time-series data Ii2(t) is subjected to Fourier transform similarly to the Fourier transform of the current time-series data (first current time-series data) Ii1(t) in S101. As a result, the current spectrum data (second current spectrum data) Ii2(f) indicating the frequency characteristic of the pseudo random pulse signal that is the input current Ii to the storage battery 6 is calculated separately from the current spectrum data Ii1(f).

In addition, the data processing section 26 performs Fourier transform on the voltage time-series data (second voltage time-series data) Vm2(t) obtained by resampling the voltage time-series data Vm1(t) as described above by fast Fourier transform or the like (S108). At this time, similarly to the Fourier transform of the voltage time-series data (first voltage time-series data) Vm1(t) in S102, the voltage time-series data Vm2(t) is subjected to Fourier transform. As a result, voltage spectrum data (second voltage spectrum data) Vm2(f) indicating frequency characteristic of the voltage Vm that is a voltage component corresponding to the fluctuation voltage of the storage battery 6 is calculated separately from the voltage spectrum data Vm1(f).

Then, the data processing section 26 performs calculation using a current spectrum data Ii2(f) and a voltage spectrum data Vm2(f) (S109). At this time, calculation similar to that in S103 is performed. Impedance spectrum data (second impedance spectrum data) Za2(f) indicating the frequency characteristic of the impedance Z of the storage battery 6 is calculated separately from the impedance spectrum data Zal(f) by calculation using the current spectrum data Ii2(f) and the voltage spectrum data Vm2(f). An impedance spectrum data Za2(f) is calculated, for example, by dividing the voltage spectrum data Vm2(f) by the current spectrum data Ii2(f). Similarly to the impedance spectrum data Zal(f), the impedance spectrum data Za2(f) also indicates an impedance component at each of a large number of frequencies included in the measurement frequency range for the impedance Z of the storage battery 6.

In the example of FIG. 9, the data processing section 26 performs averaging processing on the impedance spectrum data Za2(f) that is the measurement data of the frequency characteristic of the impedance Z of the storage battery 6 (S110). At this time, averaging processing is performed on the impedance spectrum data Za2(f) similarly to the averaging processing on the impedance spectrum data Zal(f) in S104. Therefore, the data processing section 26 performs averaging processing on the impedance spectrum data Za2(f), which is the measurement data of the frequency characteristic of the impedance of the storage battery 6, in a state where the processed data points are at equal intervals in the logarithmic scale of the frequency f. The averaging-processed data (second averaging-processed data) Zb2(f), which is the impedance spectrum data subjected to the averaging processing, is generated separately from the averaging-processed data Zb1(f) by the averaging processing on the impedance spectrum data Za2(f).

In the example of FIG. 9, the data processing section 26 performs the data selection processing on the averaging-processed data Zb1(f) and Zb2(f) calculated as described above (S111). Through the data selection processing on the averaged data Zb1(f) and Zb2(f), the selection-processed data Z0(f) is calculated as the final impedance spectrum data on the frequency characteristic of the impedance Z of the storage battery 6.

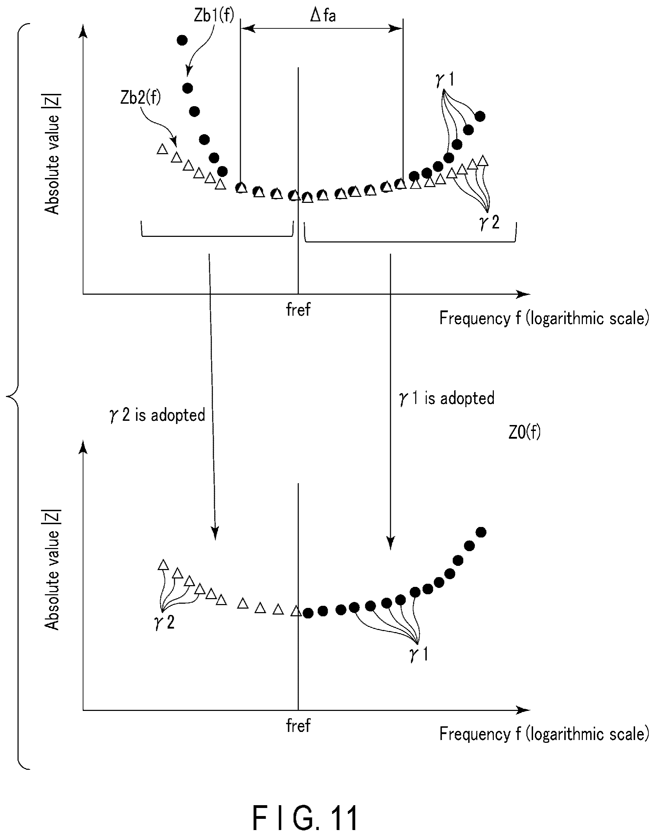

FIG. 11 illustrates an example of data selection processing performed by the data processing section 26 on the two pieces of averaging-processed data Zb1(f) and Zb2(f). In FIG. 11, the data selection processing will be described using a graph in which the abscissa axis indicates the frequency f on a logarithmic scale and the ordinate axis indicates the absolute value |Z| of the impedance Z of the storage battery 6. In FIG. 11, a data point γ1 in the averaging-processed data (first averaging-processed data) Zb1(f) is indicated by black circles, and a data point γ2 in the averaging-processed data (second averaging-processed data) Zb2(f) is indicated by hollow triangles. As illustrated in FIG. 11, in the data selection processing by the data processing section 26, a reference frequency fref is defined. The reference frequency fref is included in a measurement frequency range in which the impedance Z of the storage battery 6 is to be measured.

In the example of FIG. 11, in a frequency range Δfa included in the measurement frequency range of the impedance Z, a data point γ1 in the averaging-processed data Zb1(f) and a data point γ2 in the averaging-processed data Zb2(f) do not deviate from each other or hardly deviate from each other. On the other hand, also in the measurement frequency range of the impedance Z, the data points γ1 and γ2 are deviated from each other in a high frequency region and a low frequency region with respect to the frequency range Δfa. The reference frequency fref is included in the frequency range Δfa. In one example, a range of 0.1 Hz or more and 5000 Hz or less is a measurement frequency range for measuring the impedance Z, and the reference frequency fref is set to 2 Hz.

In the data selection processing, the data processing section 26 calculates an impedance indicated by the averaging-processed data Zb1(f) as the impedance Z of the storage battery 6 for frequencies equal to or higher than a reference frequency fref. On the other hand, the data processing section 26 calculates an impedance indicated by the averaging-processed data Zb2(f) as the impedance Z of the storage battery 6 for frequencies lower than the reference frequency fref. Therefore, in the selection-processed data Z0(f) that is the final measurement data on the frequency characteristic of the impedance Z of the storage battery 6, the data point γ1 of the averaging-processed data Zb1(f) is adopted for the impedance Z at a frequency equal to or higher than the reference frequency fref, and the data point γ2 of the averaging-processed data Zb2(f) is adopted for the impedance Z at a frequency lower than the reference frequency fref.

In the example of FIG. 9, as described above, in addition to the processing of S101 to S104, the processing of S105 to S111 is performed by the data processing section 26. Therefore, in the measurement of the frequency characteristic of the impedance Z of the storage battery 6, the data processing section 26 calculates the impedance Z of the storage battery 6 based on the current time-series data (first current time-series data) Ii1(t) and the voltage time-series data (first voltage time-series data) Vm1(t) for frequencies equal to or higher than the reference frequency fref. In the measurement of the frequency characteristic of the impedance Z of the storage battery 6, the data processing section 26 calculates the impedance Z of the storage battery 6 based on the current time-series data (second current time-series data) Ii2(t) obtained by resampling the current time-series data Ii1(t) and the voltage time-series data (second voltage time-series data) Vm2(t) obtained by resampling the voltage time-series data Vm1(t) for frequencies lower than the reference frequency fref.

The data processing section 26 determines the state of the storage battery 6 including the deterioration state and the like of the storage battery 6 using impedance spectrum data that is a measurement result of the frequency characteristic of the impedance Z of the storage battery 6. In the example of FIG. 4, a state of the storage battery 6 is determined using the averaging- processed data Zb1(f) as the impedance spectrum data, and in the example of FIG. 9, the state of the storage battery 6 is determined using selection- processed data Z0(f) as the impedance spectrum data.

In the determination of the state of the storage battery 6, the data processing section 26 calculates resistance components of the storage battery 6 such as an ohmic resistance of the storage battery 6 and charge transfer resistances of a positive electrode and a negative electrode of the storage battery 6 using the measured impedance spectrum data and the equivalent circuit model of the storage battery 6 stored in the storage section 22. In the equivalent circuit represented by the equivalent circuit model of the storage battery 6, a circuit constant (electrical characteristic parameter) corresponding to the impedance component of the storage battery 6 is set. In an equivalent circuit model of the storage battery 6, an arithmetic expression or the like for calculating the impedance Z of the storage battery 6 from the circuit constant is shown. Examples of the arithmetic expression indicated by an equivalent circuit model include an expression for calculating each of a real component and an imaginary component of the impedance Z of the storage battery 6 using a circuit constant, a frequency, and the like.

In calculating the resistance component of the storage battery 6, the data processing section 26 performs fitting calculation using an equivalent circuit model including the equivalent circuit described above and impedance spectrum data that is a measurement result of the frequency characteristic of the impedance Z of the storage battery 6. At this time, fitting calculation is performed using a circuit constant of the equivalent circuit of the storage battery 6 as a variable, and the circuit constant (electrical characteristic parameter) to be a variable is calculated. In the fitting calculation, for example, the value of the circuit constant to be a variable is determined in a state where a difference between the calculation result of the impedance Z using the arithmetic expression represented by the equivalent circuit model and the measurement result of the impedance Z is as small as possible at each frequency at which the impedance Z is measured.

The data processing section 26 calculates the circuit constant of the equivalent circuit by the fitting calculation as described above, thereby calculating the resistance component of the storage battery 6 based on the calculated value of the circuit constant. The equivalent circuit of the storage battery and the circuit constant set in the equivalent circuit are disclosed in Patent Literature 4 (Jpn. Pat. Appln. KOKAI Publication No. 2017-106889). Patent Literature 4 also discloses a method of calculating a circuit constant of an equivalent circuit and a resistance component of a storage battery by performing fitting calculation using a measurement result of a frequency characteristic of impedance of the storage battery and an equivalent circuit model of the storage battery.

In the determination on the state of the storage battery 6, the frequency characteristic of the impedance Z of the storage battery 6 is measured as described above while the storage battery 6 is in each of the plurality of target SOCs. The data processing section 26 calculates the resistance component and the like of the storage battery 6 based on the impedance spectrum data that is the measurement result of the frequency characteristic of the impedance Z for each of the plurality of target SOCs.

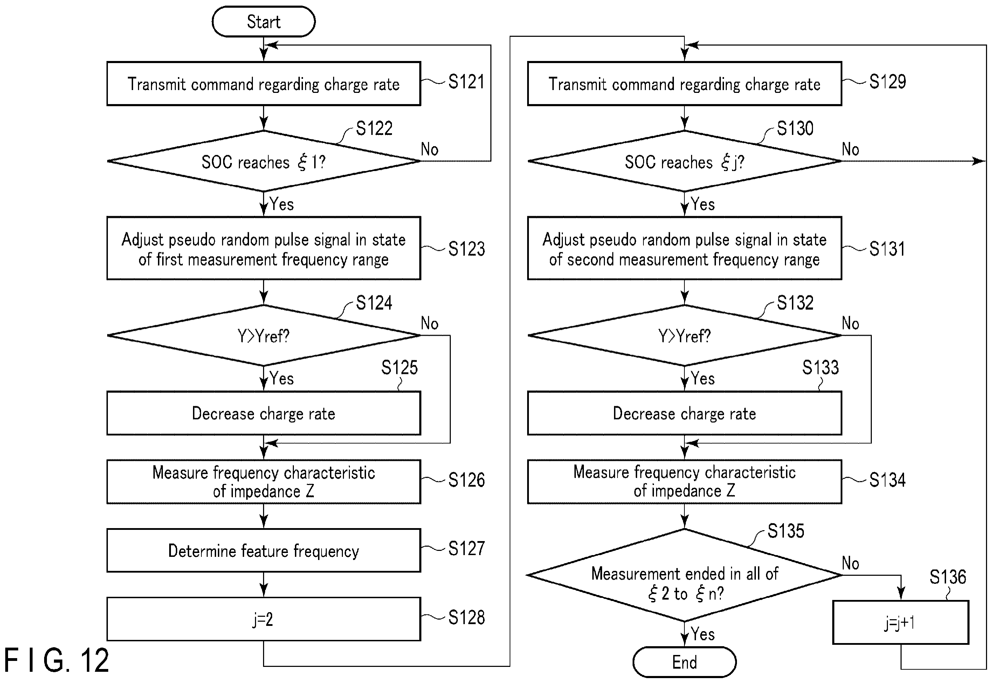

FIG. 12 illustrates an example of processing performed by the processing execution section 21 including the input current adjustment section 25 and the data processing section 26 in the determination on the state of the storage battery 6. The processing of the example of FIG. 12 is performed in a state where the storage battery 6 is charged by the charging device 2. In the example of FIG. 12, the frequency characteristic of the impedance Z of the storage battery 6 is measured for each of the target SOCs ξ1 to ξn of the number of targets n (n is a natural number of 2 or more). The processing execution section 21 determines target SOCs ξ1 to ξn for measuring the frequency characteristic of the impedance Z before determining the state of the storage battery 6.

In the determination of the target SOCs ξ1 to ξn, the processing execution section 21 measures the real-time open-circuit voltage (OCV) of the storage battery 6 and estimates the real-time SOC of the storage battery 6 based on the measurement result of the open-circuit voltage and the relationship between the open-circuit voltage and the SOC stored in the storage section 22. Then, the processing execution section 21 determines the SOC of the number of targets n higher than the real-time SOC as the target SOCs ξ1 to ξn based on the estimated real-time SOC. Note that the determined target SOCs ξ1 to ξn are set as the target SOCs ξ1, ξ2, ξ3,..., and ξn in the ascending order of the SOC. Therefore, among the target SOCs ξ1 to ξn, the SOC is the lowest in the target SOC ξ1 and the SOC is the highest in the target SOC ξn. In one example, the processing execution section 21 may receive information regarding the SOC of the storage battery 6 from the charging device 2 or the electricity storage device 3.

When the processing of the example of FIG. 12 is started, the processing execution section 21 transmits a command regarding the charge rate of the charge current Ic output from the electric power supply circuit 11 to the control section 12 of the charging device 2 (S121). At this time, the control section 12 of the charging device 2 causes the electric power supply circuit 11 to output the charge current Ic at the charge rate corresponding to the command to charge the storage battery 6. Then, the processing execution section 21 determines whether the SOC of the storage battery 6 reaches the target SOC ξ1 (S122). In a case where the SOC has not reached the target SOC ξ1 (S122-No), the processing returns to S121, and the processing execution section 21 sequentially performs the processing in and after S121. Therefore, the charging of the storage battery 6 is continued until the SOC reaches the target SOC ξ1.

The processing execution section 21 measures the real-time closed circuit voltage (CCV) of the storage battery 6 as the voltage Vd of the storage battery 6 based on the inter-terminal voltage time-series data Vd(t) in regard to the voltage (inter-terminal voltage) Vd of the storage battery 6. Then, the processing execution section 21 calculates the real-time open circuit voltage of the storage battery 6 using the measurement result of the closed circuit voltage, the measurement result of the input current Ii to the storage battery 6, and a resistance component of the storage battery 6. At this time, the resistance value and the like of the resistance component of the storage battery 6 used for the calculation are calculated based on the measurement result of the frequency characteristic of the impedance Z, the calculation result of the resistance component, and the like in the past determination on the state of the storage battery 6. Then, the processing execution section 21 estimates the real-time SOC of the storage battery 6 based on the calculated open-circuit voltage of the storage battery 6 and the relationship between the open-circuit voltage of the storage battery 6 and the SOC stored in the storage section 22, and determines whether the estimated real-time SOC has reached the target SOC ξ1. In one example, instead of estimating the real-time SOC of the storage battery 6 based on the open circuit voltage or the like of the storage battery 6, the processing execution section 21 may estimate the real-time SOC of the storage battery 6 by a so-called current integration method. In another example, the processing execution section 21 may receive information on the SOC of the storage battery 6 from the charging device 2 or the electricity storage device 3, and estimate the real-time SOC of the storage battery 6 based on the received information.

When the SOC reaches the target SOC ξ1 (S122-Yes), the input current adjustment section 25 of the processing execution section 21 generates a pseudo random pulse signal by controlling the drive of the drive circuit 31, and inputs the generated pseudo random pulse signal to the storage battery 6 as the input current Ii. Then, by controlling driving of the drive circuit 31, the input current adjustment section 25 adjusts the pseudo random pulse signal input to the storage battery 6 so that the measurement frequency range for measuring the impedance Z becomes a first measurement frequency range (S123). The first measurement frequency range is set to a relatively wide frequency range, and for example, a frequency range of 0.1 Hz or more and 5000 Hz or less is set as the first frequency range.

Here, the input current adjustment section 25 adjusts any one of the signal length Y of the pseudo random pulse signal input to the storage battery 6, the pulse width w of one or more of the pulses p included in the pseudo random pulse signal, and the number of pulses p included in the pseudo random pulse signal, thereby adjusting the measurement frequency range for measuring the impedance Z of the storage battery 6. In one example, the input current adjustment section 25 changes the measurement frequency range for measuring the impedance Z by changing the pulse width w of all the pulses p included in the pseudo random pulse signal at a uniform ratio. In another example, the input current adjustment section 25 changes the measurement frequency range for measuring the impedance Z by changing the number of pulses p included in the pseudo random pulse signal. In a case where the impedance of the storage battery 6 is measured as described above by inputting the pseudo random pulse signal to the storage battery 6, a reciprocal (1/Y) of the signal length Y of the pseudo random pulse signal corresponds to a lower limit frequency of the measurement frequency range. In addition, as described above, a pulse pmin having the smallest pulse width w among the pulses p of the pseudo random pulse signal is defined, and a pulse width wmin of the pulse pmin is defined. In a case where the impedance of the storage battery 6 is measured as described above by inputting the pseudo random pulse signal to the storage battery 6, the half value (1/ (2 · wmin)) of the reciprocal of the pulse width wmin of the pulse pmin corresponds to an upper limit frequency of the measurement frequency range.

Then, the input current adjustment section 25 determines whether the signal length Y of the pseudo random pulse signal is longer than a reference signal length Yref (S124). In a case where the signal length Y is longer than the reference signal length Yref (S124-Yes), the input current adjustment section 25 decreases the charge rate of the charge current Ic output from the electric power supply circuit 11 from a real time by transmitting a command or the like to the control section 12 of the charging device 2 (S125). Then, the input current adjustment section 25 inputs the pseudo random pulse signal to the storage battery 6 as described above in a state where the charge rate of the charge current Ic is decreased.

Then, in a state where the pseudo random pulse signal is input to the storage battery 6, the data processing section 26 measures the frequency characteristic of the impedance Z of the storage battery 6 as described above (S126). As a result, impedance spectrum data such as the averaging-processed data Zb1(f) in the example of FIG. 4 and the selection-processed data Z0(f) in the example of FIG. 9 is acquired as the measurement result of the frequency characteristic of the impedance Z of the storage battery 6 at the target SOC ξ1. In addition, the data processing section 26 calculates the resistance component of the storage battery 6 as described above based on the impedance spectrum data that is the measurement result of the frequency characteristic of the impedance Z. In a case where the signal length Y of the pseudo random pulse signal is equal to or less than the reference signal length Yref (S124-No), the processing of S126 is performed without performing the processing of S125. That is, the frequency characteristic of the impedance Z of the storage battery 6 is measured without decreasing the charge rate of the charge current Ic, and the resistance component and the like of the storage battery 6 are calculated.

The data processing section 26 determines the feature frequency of the impedance Z of the storage battery 6 based on the impedance spectrum data that is the measurement result of the frequency characteristic of the impedance Z of the storage battery 6 at the target SOC ξ1 (S127). A feature frequency for the impedance Z includes, for example, a vertex frequency. Here, in an impedance locus in the complex impedance plot of the impedance Z illustrated in FIG. 5 and the like, a portion protruding upward (negative side of the imaginary component) is formed. The frequency at a vertex of the portion protruding upward in the impedance locus, that is, the frequency at which the imaginary component of the impedance Z is locally minimum in the impedance locus is the vertex frequency. In the example of FIG. 5, a frequency at a data point Xtop is a vertex frequency.

Furthermore, in the processing of the example of FIG. 12, a setting parameter j is defined. The setting parameter j can be set to any one of natural numbers of 2 or more and n or less. After determining the feature frequency such as the vertex frequency, the processing execution section 21 sets the setting parameter j to 2 (S128). Then, the processing execution section 21 transmits a command regarding the charge rate of the charge current Ic to the control section 12 of the charging device 2 (S129), and the control section 12 of the charging device 2 charges the storage battery 6 at a charge rate corresponding to the command. At this time, the generation of the pseudo random pulse signal by the drive circuit 31 is stopped, and all of the charge current Ic from the electric power supply circuit 11 is input to the storage battery 6 as the input current Ii. Then, the processing execution section 21 determines whether the SOC of the storage battery 6 reaches the target SOC ξj (S130). In a case where the SOC has not reached the target SOC ξj (S130-No), the processing returns to S129, and the processing execution section 21 sequentially performs the processing in and after S129. Therefore, charging of the storage battery 6 is continued until the SOC reaches the target SOC ξj.

In the determination of whether the SOC of the storage battery 6 has reached the target SOC ξj, similarly to the determination of whether the SOC of the storage battery 6 has reached the target SOC ξ1 in S122, the processing execution section 21 calculates the real-time open circuit voltage of the storage battery 6 using the measurement result of the closed circuit voltage, the measurement result of the input current Ii to the storage battery 6, and the resistance component of the storage battery 6. At this time, the resistance value and the like of the resistance component of the storage battery 6 used for the calculation are calculated based on the measurement result of the frequency characteristic of the impedance Z, the calculation result of the resistance component, and the like at the target SOC ξ1 or the target SOC ξj-1. Then, the processing execution section 21 estimates the real-time SOC of the storage battery 6 based on the calculated open-circuit voltage of the storage battery 6 and the relationship between the open-circuit voltage of the storage battery 6 and the SOC stored in the storage section 22, and determines whether the estimated real-time SOC has reached the target SOC ξj. In one example, instead of estimating the real-time SOC of the storage battery 6 based on the open circuit voltage or the like of the storage battery 6, the processing execution section 21 may estimate the real-time SOC of the storage battery 6 by a so-called current integration method. In another example, the processing execution section 21 may receive information on the SOC of the storage battery 6 from the charging device 2 or the electricity storage device 3, and estimate the real-time SOC of the storage battery 6 based on the received information.

When the SOC reaches the target SOC ξj (S130-Yes), the input current adjustment section 25 of the processing execution section 21 generates a pseudo random pulse signal by controlling the drive of the drive circuit 31 and inputs the generated pseudo random pulse signal to the storage battery 6 as the input current Ii. Then, by controlling driving of the drive circuit 31, the input current adjustment section 25 adjusts the pseudo random pulse signal input to the storage battery 6 so that the measurement frequency range for measuring the impedance Z becomes a second measurement frequency range (S131). As described above, the input current adjustment section 25 adjusts the measurement frequency range for measuring the impedance Z of the storage battery 6 by adjusting the signal length Y of the pseudo random pulse signal input to the storage battery 6 and any one or more widths w of the pulses p included in the pseudo random pulse signal.

Here, the second measurement frequency range is set narrower than the first measurement frequency range. However, the second measurement frequency range includes a feature frequency determined in S127. In one example, the second frequency range is set to a relatively narrow frequency range in a vertex frequency that is a feature frequency and the vicinity thereof. Therefore, in the measurement of the frequency characteristic of the impedance Z of the storage battery 6 after the determination of the feature frequency, the input current adjustment section 25 of the processing execution section 21 reduces the measurement frequency range as compared with that before the determination of the feature frequency on condition that the feature frequency is included in the measurement frequency range for measuring the impedance Z of the storage battery 6.

Then, the input current adjustment section 25 determines whether the signal length Y of the pseudo random pulse signal is longer than the reference signal length Yref (S132). In a case where the signal length Y is longer than the reference signal length Yref (S132-Yes), the input current adjustment section 25 decreases the charge rate of the charge current Ic output from the electric power supply circuit 11 from the real time by transmitting a command or the like to the control section 12 of the charging device 2 (S133). Then, the input current adjustment section 25 inputs the pseudo random pulse signal to the storage battery 6 as described above in a state where the charge rate of the charge current Ic is decreased.

Then, in a state where the pseudo random pulse signal is input to the storage battery 6, the data processing section 26 measures the frequency characteristic of the impedance Z of the storage battery 6 as described above (S134). As a result, impedance spectrum data is acquired as a measurement result of the frequency characteristic of the impedance Z of the storage battery 6 at the target SOC ξj. In addition, the data processing section 26 calculates the resistance component of the storage battery 6 as described above based on the impedance spectrum data that is the measurement result of the frequency characteristic of the impedance Z. In a case where the signal length Y of the pseudo random pulse signal is equal to or less than the reference signal length Yref (S132-No), the processing of S134 is performed without performing the processing of S133. That is, the frequency characteristic of the impedance Z of the storage battery 6 is measured without decreasing the charge rate of the charge current Ic, and the resistance component and the like of the storage battery 6 are calculated.

When the frequency characteristic of the impedance Z of the storage battery 6 at the target SOC ξj is measured as described above, the processing execution section 21 stops the generation of the pseudo random pulse signal by the drive circuit 31. Then, the processing execution section 21 determines whether or not the measurement of the frequency characteristic of the impedance Z has ended in all the target SOCs ξ2 to ξn (S135). In a case where the frequency characteristic of the impedance Z is measured in all the target SOCs ξ2 to ξn (Yes in S 135), the processing of the example in FIG. 12, that is, the processing performed in the determination of the state of the storage battery 6 ends.

On the other hand, in a case where the frequency characteristic of the impedance Z is not measured in at least one of the target SOCs ξ2 to ξn (No in S 135), the processing execution section 21 adds 1 to the setting parameter j (S136). Then, the processing returns to S129, and the processing in and after S129 are sequentially performed. Therefore, the processing of S129 to S136 is repeatedly performed until the frequency characteristic of the impedance Z is measured in all the target SOCs ξ2 to ξn. By repeatedly performing the processing of S129 to S136, the frequency characteristic of the impedance Z of the storage battery 6 is measured in the ascending order of the SOC with respect to the target SOCs ξ2 to ξn, and the resistance component of the storage battery 6 is calculated.

As described above, in the present embodiment, the impedance Z of the storage battery 6 is measured based on the pseudo random pulse signal of the current input to the storage battery 6 and the temporal change of the voltage Vd of the storage battery 6 in a state where the pseudo random pulse signal of the current is input to the storage battery 6. Since the pseudo random pulse signal is input to the storage battery 6 as the input current Ii, the current signal to be input to the storage battery 6 can be generated with a simple configuration as compared with a case where the frequency characteristic of the impedance Z is measured by inputting a current signal whose current value periodically changes to the storage battery 6 at each of a large number of frequencies. Therefore, the impedance Z of the storage battery 6 can be measured with a simple configuration. In addition, since the pseudo random pulse signal is input to the storage battery 6 as the input current Ii, the frequency characteristic of the impedance Z of the storage battery 6 can be measured in a short time as compared with a case where the frequency characteristic of the impedance Z is measured by inputting a current signal whose current value periodically changes to the storage battery 6 at each of a large number of frequencies.

In the present embodiment, in the measurement of the frequency characteristic of the impedance Z of the storage battery 6, a pseudo random pulse signal of a current that changes between a first current value (for example, Iα-Iβ) larger than zero and a second current value (for example, Iα) larger than the first current value is input to the storage battery 6. Therefore, by inputting the pseudo random pulse signal to the storage battery 6, the impedance Z of the storage battery 6 can be measured in parallel with charging of the storage battery 6. This improves convenience in charging of the storage battery 6 and measuring the impedance Z.

In the present embodiment, the charge current Ic output from the electric power supply circuit 11 of the charging device 2 to the storage battery 6 is shunted, so that a pseudo random pulse signal input to the storage battery 6 is generated in the measurement of the impedance Z. Therefore, the pseudo random pulse signal can be generated from the charge current Ic with a simple configuration, and the configuration in which the pseudo random pulse signal is generated from the charge current Ic such as the drive circuit 31 or the like can be downsized. In addition, since the pseudo random pulse signal is generated by shunting the charge current Ic, the impedance Z of the storage battery 6 is appropriately measured in parallel with the charging of the storage battery 6. In addition, the pseudo random pulse signal has high resistance to noise. Therefore, even if the pseudo random pulse signal is generated by shunting the charge current Ic, the frequency characteristic of the impedance Z of the storage battery 6 can be appropriately measured by inputting the generated pseudo random pulse signal to the storage battery 6.

In the present embodiment, in the analog signal indicating the temporal change of the voltage Vd of the storage battery 6, a voltage component outside the specific frequency range is removed by the band pass filter 35, so that the voltage offset relative to 0 V is reduced. For this reason, the temporal change of the voltage Vm in which the voltage offset relative to 0 V is decreased is measured with high resolution by the A/D converter 33. In addition, by removing the voltage component outside the specific frequency range, the influence of noise is reduced and the S/N is increased in the analog signal indicating the temporal change of the voltage Vm. Therefore, in the A/D converter 33, the voltage time-series data Vm1(t) indicating the temporal change of the voltage Vm is measured with high accuracy. By calculating the impedance Z of the storage battery 6 using the voltage time-series data Vm1(t) measured with high accuracy, the accuracy in measuring the frequency characteristic of the impedance Z is improved.

In one example of the present embodiment, the averaging processing is performed as described above on the impedance spectrum data, which is the measurement data of the frequency characteristic of the impedance Z of the storage battery 6, in a state where the processed data points are at equal intervals on the logarithmic scale of the frequency f. For example, in the example of FIG. 4, the averaging processing is performed on the impedance spectrum data Zal(f), and in the example of FIG. 9, the averaging processing is performed on each of the impedance spectrum data Zal(f) and Za2(f). By performing the averaging processing as described above, the influence of noise is further reduced in the impedance spectrum data (for example, averaging-processed data Zb1(f) and Zb2(f)) on which the averaging processing has been performed. In particular, in the impedance spectrum data on which the averaging processing has been performed, the influence of noise on the impedance Z is reduced in a high frequency region. By performing the analysis based on the impedance spectrum data in which the influence of noise is reduced by the averaging processing, the accuracy in the analysis of the frequency characteristic of the impedance Z of the storage battery 6 is further improved.

In one example of the present embodiment, as described above, resampling is performed on each of the current time-series data (first current time-series data) Ii1(t) based on the pseudo random pulse signal and the voltage time-series data (first voltage time-series data) Vm1(t) based on the temporal change of the voltage Vd of the storage battery 6 in a state in which the influence of the peak occurring in the analog signal is removed and the data points are reduced. For frequencies equal to or higher than the reference frequency fref, the impedance Z of the storage battery 6 is calculated based on the current time-series data Ii1(t) and the voltage time-series data Vm1(t). For frequencies lower than the reference frequency fref, the impedance Z of the storage battery 6 is calculated based on the current time-series data (second current time-series data) Ii2(t) obtained by resampling the current time-series data Ii1(t) and the voltage time-series data (second voltage time-series data) Vm2(t) obtained by resampling the voltage time-series data Vm1(t). By calculating the impedance Z of the storage battery 6 at each of the plurality of frequencies as described above, the frequency characteristic of the impedance Z of the storage battery 6 is calculated more accurately.

Actually, in the high frequency region, the impedance Z calculated based on the current time-series data Ii1(t) and the voltage time-series data Vm1(t) before the resampling tends to coincide with the case where the frequency characteristic of the impedance Z is measured by inputting the current signal in which the current value periodically changes to the storage battery 6 at each of many frequencies. On the other hand, in the low frequency region, the impedance Z calculated based on the current time-series data Ii2(t) and the voltage time-series data Vm2(t) after the resampling tends to coincide with the case where the frequency characteristic of the impedance Z is measured by inputting the current signal in which the current value periodically changes to the storage battery 6 at each of many frequencies. Therefore, by analyzing the frequency characteristic of the impedance Z of the storage battery 6 in the same manner as in the example of FIG. 9 and the like, the accuracy in the analysis is further improved.

In one example of the present embodiment, the frequency characteristic of the impedance Z of the storage battery 6 is measured using the pseudo random pulse signal in each of the plurality of target SOCs ξ1 to ξn. Then, the feature frequency of the impedance Z is determined based on the measurement result of the frequency characteristic of the impedance Z at the target SOC ξ1. In the measurement of the frequency characteristic of the impedance Z in each of the target SOCs ξ2 to ξn after the feature frequency is determined, the measurement frequency range is reduced as compared with the measurement of the frequency characteristic of the impedance Z in the target SOC ξ1 on the condition that the feature frequency is included in the measurement frequency range for measuring the impedance Z of the storage battery 6. As a result, in the measurement of the frequency characteristic of the impedance Z in each of the target SOCs ξ2 to ξn, the measurement time can be shortened and the data amount can be reduced.

The measurement frequency range for measuring the impedance of the storage battery 6 is adjusted by adjusting one of the signal length Y of the pseudo random pulse signal, the pulse width w of one or more of the pulses p included in the pseudo random pulse signal, and the number of pulses p included in the pseudo random pulse signal. Therefore, by adjusting the driving state of the drive circuit 30 by adjusting the switching operation of the switch 32 or the like, the measurement frequency range for measuring the impedance of the storage battery 6 can be easily adjusted.

Further, in the present embodiment, the charge rate of the charge current Ic output from the electric power supply circuit 11 to the storage battery 6 is decreased from the real time based on the fact that the signal length Y of the pseudo random pulse signal of the current input to the storage battery 6 is longer than the reference signal length Yref. This effectively prevents a large change in the SOC of the storage battery 6 while the pseudo random pulse signal is input to the storage battery 6. Therefore, the frequency characteristic of the impedance Z of the storage battery 6 is more appropriately measured in each of the plurality of target SOCs ξ1 to ξn.

In the present embodiment, the measurement apparatus 5 is provided separately from the charging device 2 including the electric power supply circuit 11 and the electricity storage device 3 including the storage battery 6. Therefore, the impedance Z of the storage battery 6 can be measured using the measurement apparatus 5 without changing the configurations and the like of the charging device 2 and the electricity storage device 3. Therefore, it is not necessary to provide an electric power supply for measuring the impedance Z separately from the electric power supply circuit 11 of the charging device 2.

### (Modifications)

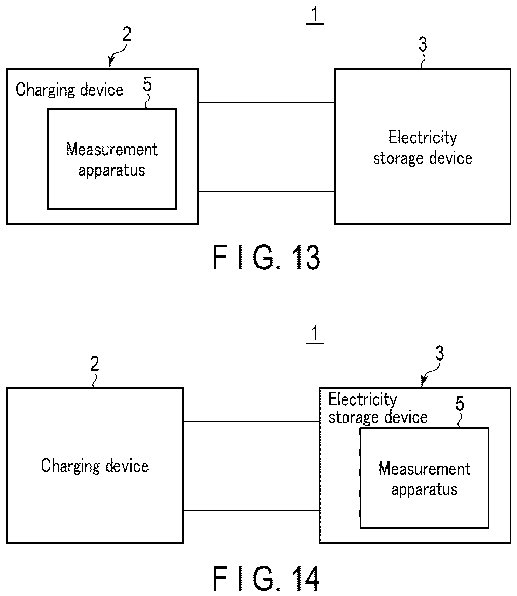

In the above-described embodiment and the like, the measurement apparatus 5 is separated from the charging device 2 including the electric power supply circuit 11 and the electricity storage device 3 including the storage battery 6, but it is not limited thereto. In a first modification illustrated in FIG. 13, a measurement apparatus 5 is incorporated in a charging device 2. Also in the present modification, an impedance Z of a storage battery 6 is measured by inputting a pseudo random pulse signal of a current that changes between a first current value larger than zero and a second current value larger than the first current value to the storage battery 6. Therefore, also in the present modification, similarly to the above-described embodiment and the like, the impedance Z of the storage battery 6 can be measured with a simple configuration, and convenience in charging of the storage battery 6 and measuring the impedance Z is improved.

Similarly in this modification, the charge current Ic output from the electric power supply circuit 11 of the charging device 2 to the storage battery 6 is shunted, so that a pseudo random pulse signal input to the storage battery 6 is generated in the measurement of the impedance Z. Therefore, it is possible to downsize the configuration in which the pseudo random pulse signal is generated from the charge current Ic such as the drive circuit 31 and the like. Since the configuration in which the pseudo random pulse signal is generated in the measurement apparatus 5 incorporated in the charging device 2 is downsized, any one of the arithmetic device, the server, the communication module, and the like having high processing performance can be mounted on the charging device 2. As a result, in the charging device 2, data analysis and management can be easily performed, and the accuracy of data analysis is improved.

In a second modification shown in FIG. 14, a measurement apparatus 5 is incorporated in an electricity storage device 3. Also in the present modification, an impedance Z of a storage battery 6 is measured by inputting a pseudo random pulse signal of a current that changes between a first current value larger than zero and a second current value larger than the first current value to the storage battery 6. Therefore, also in the present modification, similarly to the above-described embodiment and the like, the impedance Z of the storage battery 6 can be measured with a simple configuration, and convenience in charging of the storage battery 6 and measuring the impedance Z is improved.

In the present modification, since the measurement apparatus 5 is incorporated in the electricity storage device 3, the impedance Z of the storage battery 6 can be measured using the measurement apparatus 5 incorporated in the electricity storage device 3 without changing the configuration or the like of the charging device 2. Therefore, it is not necessary to provide an electric power supply for measuring the impedance Z separately from the electric power supply circuit 11 of the charging device 2.

According to at least one of these embodiments or examples, a pseudo random pulse signal of a current varying between a first current value greater than zero and a second current value greater than the first current value is input to the storage battery. Then, the impedance of the storage battery is measured based on the pseudo random pulse signal of the current input to the storage battery and the temporal change of the voltage of the storage battery in a state where the pseudo random pulse signal of the current is input to the storage battery. Accordingly, it is possible to provide a measurement apparatus, an electricity storage system, and a measurement method that enable measurement of impedance of a storage battery with a simple configuration and improve convenience in charging of the storage battery and measurement of impedance.

Although some embodiments of the invention have been described, these embodiments are for purposes of illustration and are not intended to limit the scope of the invention. These novel embodiments may be implemented in various other forms and may be omitted, substituted, or changed in various ways without departing from the gist of the invention. These embodiments and modifications thereof are included in the scope and gist of the invention and are included in the invention disclosed in the claims and the equivalent scope thereof.

## Claims

1. A measurement apparatus comprising a processing circuit performing:
inputting a pseudo random pulse signal of a current varying between a first current value greater than zero and a second current value greater than the first current value to a storage battery; and
measuring an impedance of the storage battery based on the pseudo random pulse signal of the current input to the storage battery and a temporal change of a voltage of the storage battery in a state where the pseudo random pulse signal of the current is input to the storage battery.

2. The measurement apparatus according to claim 1, wherein the processing circuit generates the pseudo random pulse signal of the current by shunting a charge current output from an electric power supply circuit to the storage battery.

3. The measurement apparatus according to claim 1, further comprising a band-pass filter that reduces a voltage offset relative to 0 V in an analog signal indicating the temporal change of the voltage of the storage battery.

4. The measurement apparatus according to claim 1, wherein the processing circuit performs averaging processing on measurement data of the frequency characteristic of the impedance of the storage battery in a state where data points after processing are at equal intervals on a logarithmic scale of frequency.

5. The measurement apparatus according to claim 1, wherein the processing circuit performs resampling on each of first current time-series data based on the pseudo random pulse signal of the current and first voltage time-series data based on the temporal change of the voltage of the storage battery in a state where the pseudo random pulse signal is input to the storage battery, in a state where an influence of a peak occurring in an analog signal is removed and the data points decrease.

6. The measurement apparatus according to claim 5, wherein in the measurement of the frequency characteristic of the impedance of the storage battery, the processing circuit calculates the impedance of the storage battery based on the first current time-series data and the first voltage time-series data for a frequency equal to or higher than a reference frequency, and calculates the impedance of the storage battery based on second current time-series data obtained by resampling the first current time-series data and second voltage time-series data obtained by resampling the first voltage time-series data for a frequency lower than the reference frequency.

7. The measurement apparatus according to claim 1, wherein
the processing circuit determines a feature frequency of the impedance of the storage battery based on a measurement result of a frequency characteristic of the impedance of the storage battery, and
in the measurement of the frequency characteristic of the impedance of the storage battery after the feature frequency is determined, the processing circuit reduces the measurement frequency range on condition that the feature frequency is included in a measurement frequency range for measuring the impedance of the storage battery.

8. The measurement apparatus according to claim 7, wherein the processing circuit adjusts one of a signal length of the pseudo random pulse signal of the current input to the storage battery, a pulse width of one or more of pulses included in the pseudo random pulse signal, and the number of pulses included in the pseudo random pulse signal to adjust the measurement frequency range for measuring the impedance of the storage battery.

9. The measurement apparatus according to claim 7, wherein the processing circuit decreases a charge rate of a charge current output from an electric power supply circuit to the storage battery based on a fact that the signal length of the pseudo random pulse signal of the current input to the storage battery is longer than a reference signal length.

10. An electricity storage system comprising:
the measurement apparatus according to any one of claims 1 to 9; and
an electricity storage device including the storage battery to which the pseudo random pulse signal of the current is input from the measurement apparatus, the impedance of the storage battery being measured by the measurement apparatus.

11. The energy storage system according to claim 10, further comprising a charging device including an electric power supply circuit that outputs a charge current to the storage battery,
wherein the processing circuit of the measurement apparatus generates the pseudo random pulse signal of the current by shunting the charge current output from the electric power supply circuit.

12. The energy storage system according to claim 11, wherein the measurement apparatus is provided separately from the electricity storage device and the charging device, or is incorporated in the electricity storage device or the charging device.

13. A measurement method comprising:
inputting a pseudo random pulse signal of a current varying between a first current value greater than zero and a second current value greater than the first current value to a storage battery; and
measuring an impedance of the storage battery based on the pseudo random pulse signal of the current input to the storage battery and a temporal change of a voltage of the storage battery in a state where the pseudo random pulse signal of the current is input to the storage battery.
